# FASCICULE DE BREVET EUROPEEN

(11) **EP 3 465 784 B1**
(45) Date de publication et mention de la délivrance du brevet: **08.04.2020**
(21) Numéro de dépôt: 17732512.3
(22) Date de dépôt: 30.05.2017
(51) Int. Cl.: H01L 41/08, H01L 41/312, H03H 9/02, H03H 3/10

(54) **STRUCTURE HYBRIDE POUR DISPOSITIF A ONDES ACOUSTIQUES DE SURFACE**
HYBRIDSTRUKTUR FÜR EINE OBERFLÄCHENSCHALLWELLENVORRICHTUNG
HYBRID STRUCTURE FOR A SURFACE ACOUSTIC WAVE DEVICE

(30) Priorité: 02.06.2016 FR 1655030
(43) Date de publication de la demande: 10.04.2019
(73) Titulaire: Soitec, 38190 Bernin (FR)
(72) Inventeur: BROEKAART, Marcel, 38570 THEYS (FR)
(74) Mandataire: IP Trust
(86) Numéro de dépôt international: PCT/FR2017/051339
(87) Numéro de publication internationale: WO 2017/207911

(56) Documents cités:
- EP-A1- 2 658 123
- DE-A1-102004 045 181
- US-A1- 2009 224 853
- US-A1- 2016 065 162

## Description

### DOMAINE DE L'INVENTION

La présente invention concerne le domaine des dispositifs à ondes acoustiques de surface. Elle concerne en particulier une structure hybride adaptée pour la fabrication de dispositifs à ondes acoustiques de surface.

### ARRIERE PLAN TECHNOLOGIQUE DE L'INVENTION

Les structures de résonateurs acoustiques telles que les dispositifs à ondes acoustiques de surface (« SAW » pour « Surface Acoustic Wave » selon la terminologie anglo-saxonne) utilisent un ou plusieurs transducteurs interdigités élaborés sur un substrat piézoélectrique pour convertir des signaux électriques en ondes acoustiques et vice versa. De tels dispositifs ou résonateurs SAW sont souvent utilisés dans les applications de filtrage. La technologie SAW à radiofréquences (RF) fournit d'excellentes performances telles qu'une haute isolation et de faibles pertes d'insertion. Pour cette raison, elle est utilisée pour les duplexeurs RF dans les applications de communication sans fil. Néanmoins, pour être plus concurrentielle par rapport aux duplexeurs RF basés sur la technologie des ondes acoustiques de volume (« BAW » pour « Bulk Acoustic Wave »), la performance des dispositifs SAW RF doit être améliorée et l'on exige en particulier que la réponse en fréquence soit stable vis-à-vis de la température.

La dépendance de la fréquence de fonctionnement des dispositifs SAW vis-à-vis de la température, ou le coefficient de fréquence thermique (« TCF » pour « Temperature Coefficient of Frequency »), dépend d'une part des variations de l'espacement entre les électrodes interdigitées des transducteurs, qui sont généralement dues aux coefficients de dilatation thermique (« CTE » pour « Coefficient of Thermal Expansion ») relativement élevés des substrats piézoélectriques utilisés ; d'autre part, le TCF dépend du coefficient de vitesse thermique car la dilatation ou la contraction du substrat piézoélectrique s'accompagne d'une augmentation ou d'une diminution de la vitesse de l'onde acoustique de surface. Pour minimiser le coefficient de fréquence thermique (TCF), un objectif est donc de minimiser la dilatation/contraction du substrat piézoélectrique, notamment dans la zone de surface dans laquelle les ondes acoustiques vont se propager.

L'article de K.Hashimoto, M.Kadota et al, « Recent development of temperature compensated SAW devices », IEEE Ultrason. Symp. 2011, pages 79 à 86, 2011, donne une vue d'ensemble des approches couramment utilisées pour surmonter le problème de dépendance vis-à-vis de la température de la réponse en fréquence des dispositifs SAW.

Une approche consiste à utiliser un substrat hybride, par exemple composé d'une couche de matériau piézoélectrique disposée sur un substrat de silicium. Le CTE faible du silicium permet de limiter la dilatation/contraction de la couche piézoélectrique en température. Dans le cas d'une couche piézoélectrique de Tantalate de Lithium (LiTaO3), l'article précédemment cité indique qu'un ratio de 10 entre l'épaisseur de LiTaO3 et l'épaisseur du substrat de silicium permet d'améliorer convenablement le coefficient de fréquence thermique (TCF). L'un des inconvénients de cette approche vient de la présence d'ondes acoustiques parasites (appelées « spurious acoustic modes » dans l'article « Characterization of bonded wafer for RF filters with reduced TCF », B.P.Abbott et al, Proc 2005 IEEE International Ultrasonics Symposium, Sept 19-21, 2005, pp.926-929) qui impactent négativement les caractéristiques en fréquence du résonateur élaboré sur le substrat hybride. Ces résonances parasites sont notamment liées à des réflexions parasites de l'onde acoustique principale (se propageant principalement dans une zone superficielle de la couche de LiTaO3) sur les interfaces sous-jacentes, dont notamment l'interface entre le LiTaO3 et le silicium. Une solution pour diminuer ces résonances parasites est d'augmenter l'épaisseur de la couche de LiTa03 ; cela supposant d'augmenter également l'épaisseur du substrat de Si pour conserver les améliorations du TCF, l'épaisseur totale du substrat hybride n'est alors plus compatible avec les besoins de réduction d'épaisseur des composants finaux, notamment pour adresser le marché des téléphones cellulaires. Une autre solution, proposée par K.Hashimoto et al. est de rugosifier la surface inférieure de la couche de LiTaO3 (à l'interface de collage avec le substrat) de façon à limiter les réflexions de l'onde acoustique sur celle-ci. Une telle rugosification représente une difficulté à gérer quand un procédé de collage direct, requérant des surfaces à assembler très lisses, est utilisé pour la réalisation du substrat hybride.

US 2009/0224853 A1 divulgue un dispositif SAW comprenant une couche texturée séparée avec des cavités; en EP 2 658 123 A1, on utilise une couche de faible vitesse acoustique pour supprimer les ondes acoustique parasites.

### OBJET DE L'INVENTION

Un objet de la présente invention est de proposer une solution alternative aux solutions de l'état de l'art. Un objet de l'invention est notamment de proposer une structure hybride permettant la réduction et/ou l'élimination desdites ondes acoustiques parasites.

### BREVE DESCRIPTION DE L'INVENTION

La présente invention concerne une structure hybride pour dispositif à ondes acoustiques de surface comprenant une couche utile de matériau piézoélectrique présentant une première face libre et une deuxième face disposée sur un substrat support dont le coefficient de dilatation thermique est inférieur à celui de la couche utile. La structure hybride est remarquable en ce que la couche utile comprend une zone de nanocavités.

La zone de nanocavités est adaptée pour diffuser une onde acoustique se propageant dans l'épaisseur de la couche utile jusqu'à ladite zone ; elle réduit, voire élimine les réflexions parasites de l'onde acoustique, qui s'opèrent habituellement au niveau de la ou des interface(s) de la structure hybride et qui impactent négativement les caractéristiques en fréquence du dispositif SAW.

En outre, la zone de nanocavités est formée dans l'épaisseur de la couche utile et n'affecte pas la rugosité de la deuxième face, ce qui facilite et fiabilise l'assemblage de la couche utile sur le substrat support.

Selon des caractéristiques avantageuses de l'invention, prises seules ou en combinaison :
- la zone de nanocavités a une épaisseur fonctionnelle comprise entre 50nm et 3 microns ;
- la zone de nanocavités est plus proche de la deuxième face que de la première face de la couche utile ;
- la zone de nanocavités se situe à une distance de plus de 50nm de la deuxième face de la couche utile ;
- les nanocavités ont, au moins en partie, une dimension maximale comprise entre 1nm et 500nm ;
- les nanocavités occupent entre 10% et 20% du volume dans la zone de nanocavités ;
- les nanocavités présentent une forme sensiblement sphérique ou polyédrique ;
- tout ou partie des nanocavités contient une espèce gazeuse ;
- la zone de nanocavités s'étend dans un plan parallèle à la deuxième face de la couche utile ;
- la zone de nanocavités est continue dans un plan parallèle à la deuxième face de la couche utile ;
- la zone de nanocavités est discontinue dans un plan parallèle à la deuxième face de la couche utile ;
- le substrat support comprend un matériau choisi parmi le silicium, le verre, la silice, le saphir, l'alumine, le nitrure d'aluminium, le carbure de silicium ;
- la couche utile comprend un matériau piézoélectrique choisi parmi le tantalate de lithium (LiTaO3), le niobate de lithium (LiNbO3), le quartz, l'oxyde de zinc (ZnO) ;
- la structure hybride comprend une couche intermédiaire située entre la deuxième face de la couche utile et le substrat support.

La présente invention concerne en outre un dispositif à ondes acoustiques de surface comprenant une structure hybride telle que ci-dessus. De manière avantageuse, la fréquence des ondes acoustiques est comprise entre 700 MHz - 3 GHz.

La présente invention concerne enfin un procédé de fabrication d'une structure hybride pour un dispositif à ondes acoustiques de surface comprenant :
a) Une étape de fourniture d'une couche utile de matériau piézoélectrique présentant une première face et une deuxième face ;
b) Une étape de fourniture d'un substrat support présentant un coefficient de dilatation thermique inférieur à celui de la couche utile ;
c) Une étape d'assemblage de la deuxième face de la couche utile sur le substrat support ;

Le procédé est remarquable en ce qu'il comprend une étape d'introduction d'espèces gazeuses dans la couche utile pour former une zone de nanocavités.

Selon des caractéristiques avantageuses de l'invention, prises seules ou en combinaison :
- la couche utile fournie à l'étape a) est comprise dans un substrat donneur en matériau piézoélectrique ;
- le procédé de fabrication comprend après l'étape d'assemblage, une étape d) d'amincissement du substrat donneur jusqu'à une épaisseur utile pour former la couche utile ;
- l'étape d'introduction d'espèces gazeuses comprend au moins une implantation d'ions choisis parmi l'hydrogène, l'hélium, l'argon et autres gaz nobles ;
- Le procédé de fabrication comprend une étape de traitement thermique après l'étape d'introduction d'espèces gazeuses ;
- l'introduction d'espèces gazeuses dans la couche utile est réalisée au niveau de sa deuxième face, avant l'étape d'assemblage ;
- l'introduction d'espèces gazeuses dans la couche utile est réalisée au niveau de sa première face, après l'étape d'assemblage ;
- l'introduction d'espèces gazeuses dans la couche utile est réalisée localement par application d'un masque.

### BREVE DESCRIPTION DES DESSINS

D'autres caractéristiques et avantages de l'invention ressortiront de la description détaillée qui va suivre en référence aux figures annexées sur lesquelles :
- la figure 1 présente une structure hybride conforme à l'invention ;
- les figures 2a à 2e présentent une vue en coupe (2a) et des vues de dessus (2b à 2e) de structures hybrides conformes à l'invention ;
- la figure 3 présente une structure hybride conforme à l'invention ;
- la figure 4 présente un dispositif à ondes acoustiques de surface selon l'invention ;
- les figures 5a à 5e présentent un procédé de fabrication d'une structure hybride selon un premier mode de réalisation ;
- les figures 6a et 6b présentent un procédé de fabrication d'une structure hybride selon un deuxième mode de réalisation ;
- les figures 7a à 7c présentent un procédé de fabrication d'une structure hybride selon un troisième mode de réalisation.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y. De même, la taille des nanocavités n'est pas à l'échelle par rapport aux épaisseurs de couches ou autres dimensions latérales d'éléments de l'invention.

L'invention concerne une structure hybride 100 pour dispositif à ondes acoustiques de surface comprenant une couche utile 10 de matériau piézoélectrique présentant une première face libre 1 et une deuxième face 2 disposée sur un substrat support 20. La couche utile 10 présente typiquement une épaisseur utile comprise entre 1 micron et 50 microns, selon le type de dispositif SAW à élaborer sur la structure hybride 100. La couche utile 10 comprend avantageusement un matériau piézoélectrique choisi parmi le tantalate de lithium (LiTaO3), le niobate de lithium (LiNbO3), le quartz, l'oxyde de zinc (ZnO).

Le substrat support 20 de la structure hybride 100 présente un coefficient de dilatation thermique inférieur à celui de la couche utile 10, au moins selon un axe cristallographique dans le cas de matériaux anisotropes. Il pourra comprendre un matériau choisi parmi le silicium, le verre, la silice, le saphir, l'alumine, le nitrure d'aluminium, le carbure de silicium.

Bien-sur, cette liste de matériaux n'est pas exhaustive, d'autres substrats ou couches utiles piézoélectriques pourraient être choisis selon le type d'applications et les propriétés requises.

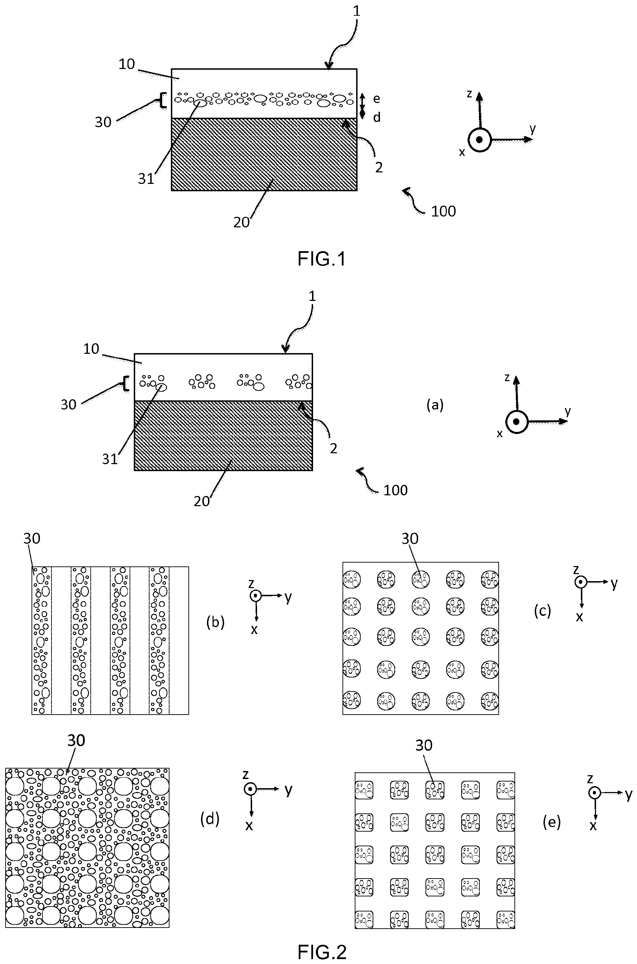

La structure hybride 100 comprend en outre une zone 30 de nanocavités 31, dans la couche utile 10, comme illustré sur la figure 1.

Préférentiellement, les nanocavités 31 ont une forme sensiblement sphérique, polyédrique ou ellipsoïdale. Cette forme est avantageuse car elle favorise une réflexion multidirectionnelle et donc la diffusion des ondes acoustiques susceptibles de se propager dans l'épaisseur de la couche utile 10, évitant ainsi leur réflexion sur une surface plane telle que l'interface entre couche utile 10 et substrat support 20. Les nanocavités 31 peuvent être vides ou contenir une espèce gazeuse ou encore un mélange d'espèces gazeuses.

Les nanocavités 31 présentent typiquement une dimension maximale comprise entre 1nm et 500nm ; par dimension maximale, on entend par exemple le diamètre de la nanocavité si celle-ci a une forme sphérique ou son diamètre le plus grand si elle est légèrement ellipsoïdale. La densité des nanocavités 31 dans la zone 30 est telle qu'elles occupent préférentiellement 10% à 20% du volume de ladite zone 30. La taille et la densité des nanocavités 31 peuvent avoir une influence sur l'efficacité de diffusion des ondes acoustiques. Ainsi, selon la fréquence de la ou les onde(s) acoustique(s) se propageant dans le dispositif qui sera élaboré sur la structure hybride 100, les paramètres de taille et de densité des nanocavités 31 pourront être ajustés.

La zone 30 de nanocavités 31 a avantageusement une épaisseur dite fonctionnelle e comprise entre 50 nm et 3 microns, selon l'axe z sur la figure 1. L'épaisseur fonctionnelle e est avantageusement choisie égale ou sensiblement inférieure à la longueur d'onde λ du signal acoustique utilisé pour le dispositif SAW, par exemple comprise entre λ et λ/8. D'autre part, la dimension maximale moyenne des nanocavités sera préférentiellement choisie inférieure ou égale à la longueur d'onde λ de l'onde acoustique ; typiquement elle pourra être comprise entre λ/10 et λ. Cette configuration favorise l'interaction entre l'onde acoustique et la zone 30 de nanocavités 31. En particulier, la portion d'onde acoustique se réfléchissant habituellement aux interfaces de la structure hybride sera avantageusement diffusée par la zone 30 : cela aura pour résultat de limiter fortement, voire d'éliminer la composante réfléchie de l'onde acoustique à l'origine des effets parasites.

Préférentiellement, la zone 30 de nanocavités 31 est à proximité de la deuxième face 2 de la couche utile 10. En particulier, elle pourra se situer à une distance d de l'ordre de 50nm de la deuxième face 2. Elle pourra alternativement se situer à une distance comprise entre quelques nm et environ 30% de l'épaisseur utile. A titre d'exemple, pour une couche utile 10 d'épaisseur utile 10 microns, la zone 30 pourra se situer à une distance comprise entre 50nm et 3 microns de la deuxième face 2.

De manière avantageuse, la zone 30 de nanocavités s'étend dans un plan parallèle à la deuxième face 2 de la couche utile 10. Elle peut être continue dans la couche utile 10, c'est-à-dire présente dans toute la structure hybride 100. Cette configuration laisse toute latitude quant au positionnement du dispositif SAW sur la structure hybride 100.

Alternativement, la zone 30 de nanocavités 31 peut être discontinue et n'être présente que localement, dans certaines régions de la couche utile 10, comme illustré sur la figure 2a. A titre d'exemple et sans que cela soit limitatif, en vue de dessus, la zone 30 de nanocavités 31 peut prendre la forme de motifs en bandes (figure 2b), de motifs circulaires (figure 2c), de régions complémentaires à des motifs circulaires (figure 2d) ou encore de motifs carrés (figure 2e). Une dimension, dans le plan (x,y), des régions comprenant la zone 30 de nanocavités est préférentiellement comprise entre 1 et 10 microns.

La discontinuité de la zone 30 de nanocavités 31 peut apporter des avantages dans le cas d'ondes acoustiques de grandes longueurs d'onde (de l'ordre de 5 microns et plus) : en effet, la présence de motifs de plus grande taille et de plus grande période que les nanocavités 31 peut favoriser l'interaction de l'onde acoustique avec la zone 30 discontinue et améliorer ainsi la diffusion de l'onde.

Selon un autre mode de mise en œuvre, la zone 30 de nanocavités locale peut être présente uniquement dans les régions sur lesquelles les électrodes du dispositif SAW seront élaborées, électrodes entre lesquelles se propageront les ondes acoustiques.

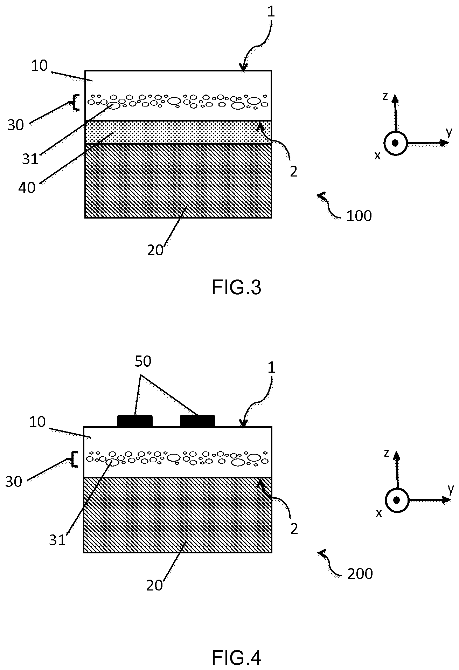

La structure hybride 100 selon l'invention peut également comporter une couche intermédiaire 40, disposée entre la deuxième face 2 de la couche utile 10 et le substrat support 20 (figure 3). Cette couche intermédiaire 40 est à titre d'exemple, constituée d'un matériau choisi parmi l'oxyde de silicium, le nitrure de silicium, le silicium amorphe ou poly-cristallin, etc. La couche intermédiaire 40 peut avoir une fonction (isolation électrique, piégeage de porteurs de charges, etc...) dans le futur dispositif SAW, qui sera élaboré sur la structure hybride 100. Elle peut également être utilisée pour faciliter l'assemblage entre la couche utile 10 et le substrat support 20, notamment pour renforcer l'énergie de collage de l'interface d'assemblage.

La structure hybride 100 selon l'invention est adaptée pour la fabrication d'un dispositif à ondes acoustiques de surface 200, dont une représentation simplifiée est donnée en figure 4. Un tel dispositif 200 comprend en particulier des électrodes métalliques 50 disposées sur la première face 1 de la couche utile 10. Une ou des onde(s) acoustique(s) seront amenées à se propager entre les électrodes 50 pendant le fonctionnement du dispositif 200.

La zone 30 de nanocavités 31 de la structure hybride 100 est adaptée pour diffuser une onde acoustique se propageant dans l'épaisseur de la couche utile 10 jusqu'à ladite zone 30 ; elle réduit, voire élimine les réflexions parasites de l'onde acoustique, qui s'opèrent habituellement au niveau de la ou des interface(s) de la structure hybride 100 et qui impactent négativement les caractéristiques en fréquence du dispositif SAW 200.

La structure hybride 100 selon l'invention est particulièrement adaptée pour la fabrication de dispositifs SAW 200 utilisant des fréquences d'ondes acoustiques comprises entre 700MHz et 3GHz.

La présente invention concerne par ailleurs un procédé de fabrication d'une structure hybride 100 pour un dispositif à ondes acoustiques de surface 200 comprenant une première étape de fourniture d'une couche utile 10 de matériau piézoélectrique présentant une première face 1 et une deuxième face 2. Le procédé de fabrication comporte également une étape de fourniture d'un substrat support 20 présentant un coefficient de dilatation thermique inférieur à celui de la couche utile 10. Il comprend aussi une étape d'assemblage de la deuxième face 2 de la couche utile 10 sur le substrat support 20. Comme connu en soi, différentes techniques d'assemblage peuvent être mises en œuvre, dont le collage par adhésion moléculaire, le collage par adhésif, ou autre type de collage adapté à la fabrication d'une structure hybride. Une couche intermédiaire 40 peut être ajoutée préalablement à l'assemblage, soit sur la deuxième face 2 de la couche utile 10, soit sur la face à assembler du substrat support 20, soit sur les deux. Cette couche intermédiaire 40 est par exemple constituée d'oxyde de silicium, de nitrure de silicium ou encore de silicium poly-cristallin et avoir une épaisseur comprise entre quelques nanomètres et quelques microns. La couche intermédiaire 40 peut être élaborée selon les différentes techniques connues de l'état de l'art, telles des traitements thermiques d'oxydation ou de nitruration, des dépôts chimiques (PECVD, LPCVD...), etc.

Le procédé de fabrication selon l'invention comprend en outre une étape d'introduction d'espèces gazeuses dans la couche utile 10 pour former une zone 30 de nanocavités 31. Cette étape peut être réalisée avant ou après l'étape d'assemblage de la couche utile 10 sur le substrat support 20. Avantageusement, l'étape d'introduction d'espèces gazeuses comprend au moins une implantation d'ions choisis parmi l'hydrogène, l'hélium, l'argon, ou autres gaz nobles. Il est bien-sur possible d'utiliser d'autres gaz, capables de former des nanocavités 31 dans la couche utile 10.

Comme bien connu par l'homme du métier, l'énergie d'implantation est choisie en fonction de la profondeur souhaitée pour la zone 30 de nanocavités 31. La dose d'ions implantés est choisie dans la gamme permettant de former des nanocavités 31 dans le matériau de la couche utile 10, de taille et de densité permettant avantageusement au nanocavités 31 d'occuper 10% à 20% du volume dans la zone 30. La dose d'ions implantés est également choisie inférieure à la dose susceptible de générer des déformations ou autres dommages au niveau de l'une ou l'autre des faces 1,2 de la couche utile 10.

Selon l'épaisseur fonctionnelle choisie de la zone 30 de nanocavités 31, une ou plusieurs étapes d'implantation d'ions pourra(ont) être effectuée(s) dans la couche active (10), à différentes énergies d'implantation, dans le but d'élargir le profil d'implantation et ainsi ladite épaisseur fonctionnelle ou dans le but de former un profil spécifique différent du profil sensiblement gaussien généré par une implantation unique.

Selon une variante, l'étape d'introduction d'espèces gazeuses peut être faite localement dans la couche utile 10. Pour cela, il est habituel d'utiliser une couche de masquage, déposée sur la face de la couche utile 10 à implanter, qui protège des régions dans lesquelles on ne souhaite pas former la zone 30 et qui laisse exposées des régions dans lesquelles la zone 30 doit être formée. Il est ainsi possible d'obtenir une structure hybride 100 telle que celles illustrées sur les figures 2a à 2e.

Le procédé de fabrication peut avantageusement comprendre une étape de traitement thermique subséquente à l'introduction d'espèces gazeuses, permettant de retirer, au moins partiellement les espèces gazeuses de la couche utile 10 et en particulier de former et/ou stabiliser les nanocavités 31 dans le matériau. Ce traitement thermique pourra, à titre d'exemple, être réalisé à une température comprise entre 200°C et 900°C, pendant une durée allant de quelques minutes à quelques heures. La température du traitement thermique sera préférentiellement choisie inférieure à la température de Curie du matériau piézoélectrique de la couche utile 10.

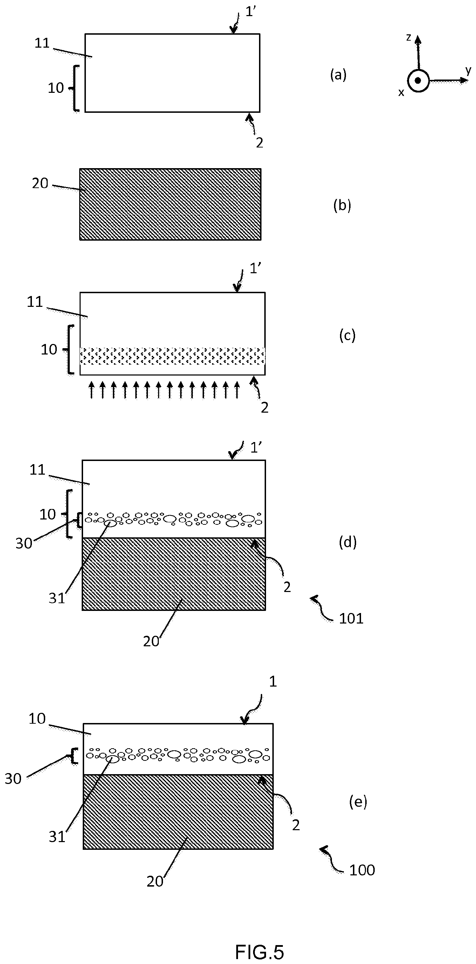

Des modes de réalisations particuliers du procédé de fabrication vont maintenant être décrits en référence aux figures 5, 6 et 7.

Selon un premier mode de réalisation de l'invention, la première étape du procédé, consiste en la fourniture d'un substrat donneur 11 en matériau piézoélectrique (figure 5a), incluant la couche utile 10. Le substrat donneur 11 comprend une première face 1' et une deuxième face 2. A titre d'exemple, il pourra être constitué d'un matériau piézoélectrique choisi parmi le tantalate de lithium (LiTaO3), le niobate de lithium (LiNbO3), le quartz, l'oxyde de zinc (ZnO).

Le substrat support 20, présentant un coefficient de dilatation thermique inférieur à celui du substrat donneur 11 est fourni dans une deuxième étape du procédé (figure 5b). Comme indiqué précédemment, il pourra par exemple comprendre un matériau choisi parmi le silicium, le verre, la silice, le saphir, l'alumine, le nitrure d'aluminium, le carbure de silicium.

Préalablement à l'étape d'assemblage, l'étape d'introduction d'espèces gazeuses est effectuée au niveau de la deuxième face du substrat donneur 11, comme illustré sur la figure 5c. Elle engendre ainsi une zone enterrée, dont l'épaisseur et la profondeur est dépendante de l'énergie et de la dose d'implantation des ions, ainsi que de la nature du substrat donneur 11. Cette zone enterrée formera la zone 30 de nanocavités 31. Selon que l'implantation sera effectuée sur la totalité de la deuxième face 2 ou localement, la zone 30 sera soit continue soit discontinue, dans un plan parallèle à la deuxième face 2.

Les nanocavités 31 sont soit directement présentes après implantation, soit formées et stabilisées par une étape subséquente de traitement thermique. Cette étape de traitement thermique présente également l'avantage, dans le présent mode de réalisation, d'exodiffuser tout ou partie des espèces gazeuses du substrat donneur 11, préalablement à l'assemblage : cela peut notamment éviter un dégazage à l'interface de collage, susceptible de dégrader sa tenue mécanique et/ou sa qualité.

Une étape d'assemblage de la deuxième face 2 du substrat donneur 11 sur le substrat support 20 est ensuite réalisée (figure 5d). Le collage par adhésion moléculaire est une technique avantageuse en ce qu'il ne nécessite pas d'ajout de matière pour assembler les surfaces. Il requiert néanmoins un bon état de surface (bonne planéité, faible rugosité, excellente propreté) pour donner lieu à un assemblage de bonne qualité. La formation de la zone 30 de nanocavités 31 selon l'invention ne dégrade pas la qualité de la deuxième face 2 ; l'étape d'introduction d'espèces gazeuses est définie de sorte que la zone enterrée ne génère pas de déformation ou de dommages au niveau de la deuxième face 2 à assembler.

Pour consolider l'interface de collage, la structure hybride collée 101 est avantageusement soumise à un traitement thermique. Il est à noter que les matériaux du substrat donneur 11 et du substrat support 20 présentent des coefficients de dilatation thermique très différents, le traitement thermique appliqué doit donc rester à une température inférieure à la température d'endommagement ou de casse de la structure collée 101. La gamme de température sera typiquement comprise entre quelques dizaines de degrés et 500°C.

Le procédé de fabrication selon ce premier mode de réalisation de l'invention comporte en outre une étape d'amincissement du substrat donneur 11, par sa première face 1', de manière à obtenir une épaisseur dite utile de la couche utile 10 et former la première face 1 libre (figure 5e). Cette épaisseur utile dépend du type de dispositif à ondes acoustiques qui sera élaboré sur la structure hybride 100.

L'étape d'amincissement peut être basée sur les techniques connues de rodage (« grinding » selon la terminologie anglo-saxonne), de polissage (CMP pour « chemical mechanical polishing ») et/ou de gravure chimique (humide ou sèche). Ces procédés sont particulièrement adaptés à la formation de couches utiles épaisses, par exemple de quelques microns à plusieurs dizaines de microns, et jusqu'à quelques centaines de microns.

Pour former une couche utile 10 de faible épaisseur, c'est-à-dire typiquement inférieure à 2 microns, d'autres procédés de transfert de couches peuvent être mis en œuvre, parmi lesquels le procédé Smart Cut™. Il est basé sur une implantation d'ions légers d'hydrogène et/ou d'hélium dans le substrat donneur 11 pour former une couche enterrée fragilisée, à une profondeur par rapport à la deuxième face 2, supérieure ou égale à l'épaisseur utile. Cette étape d'implantation peut être effectuée préalablement à l'étape d'assemblage, avant ou après la formation de la zone 30 de nanocavités 31.

Une étape de détachement, postérieure à l'assemblage sur le substrat support 20, permet ensuite de séparer une couche mince superficielle du substrat donneur 11 (la couche utile 10), au niveau de la couche enterrée fragilisée. Des étapes de finition, pouvant inclure des traitements thermiques et/ou des amincissements par polissage ou gravure chimique, confèrent enfin la qualité cristalline et de surface requise à la couche utile 10. Ce procédé est particulièrement adapté pour la fabrication de couches utiles minces.

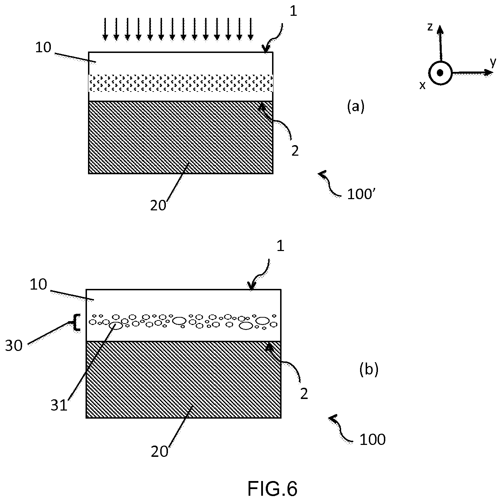

Selon un deuxième mode de réalisation de l'invention, l'étape d'introduction des espèces gazeuses dans la couche utile 10 est faite après l'étape d'assemblage. Une structure hybride 100' comprenant la couche utile 10 disposée sur le substrat support 20 est soumise à l'étape d'introduction d'espèces gazeuses pour former la zone 30 de nanocavités 31 (figure 6a). L'énergie des ions, dans le cas d'une implantation, est avantageusement choisie de sorte que la zone 30 soit formée dans le tiers inférieur de la couche utile 10, proche de la deuxième face 2.

Un traitement thermique peut être réalisé pour former et/ou stabiliser les nanocavités 31 de la zone 30. Ce traitement thermique doit prendre en compte la différence de coefficient de dilatation thermique des matériaux constituant la structure hybride 100, illustrée sur la figure 6b.

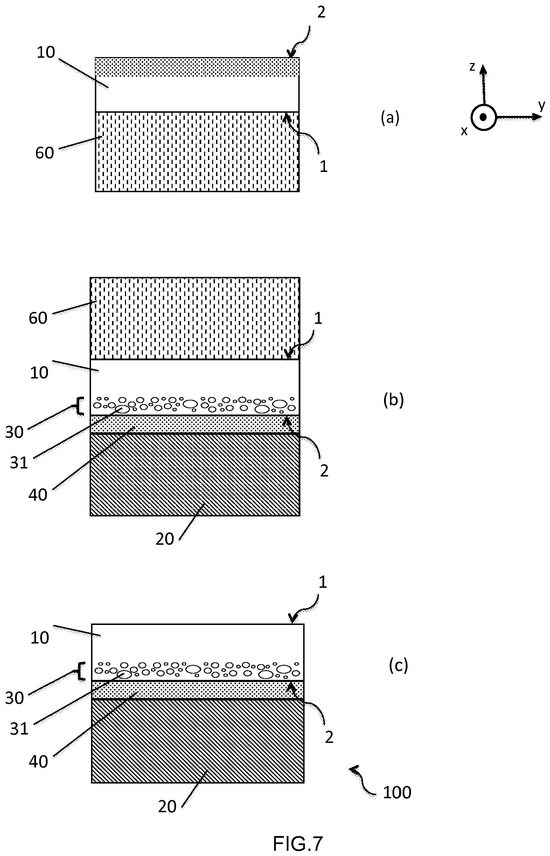

Selon un troisième mode de réalisation de l'invention, lors de la première étape de fourniture du procédé, la première face 1 de la couche utile 10 est disposée sur un substrat temporaire 60 (figure 7a). Elle a avantageusement été reportée par le procédé Smart Cut et comporte donc un résidu de la couche enterrée fragilisée au niveau de sa deuxième face 2.

Préférentiellement, une couche intermédiaire 40 est déposée sur la deuxième face 2 de la couche utile 10 préalablement à son assemblage sur le substrat support 20 (figure 7b).

Le substrat temporaire 60 est ensuite retiré, soit par amincissement mécanique ou chimique, soit par démontage au niveau de l'interface entre la première face 1 de la couche utile 10 et le substrat temporaire 60.

La figure 7c présente la structure hybride 100 obtenue : le résidu de la couche enterrée fragilisée formée pendant le procédé Smart Cut permet de générer, dans ce mode de réalisation, la zone 30 de nanocavités 31, à proximité de la deuxième face 2 de la couche utile 10.

Ce troisième mode de réalisation est avantageux lorsque les coefficients de dilatation (CTE) des matériaux de la structure hybride 100 rendent difficile l'application directe du procédé Smart Cut pour le transfert d'une couche utile 10 mince sur le substrat support 20. Dans ce cas, la couche utile 10 est d'abord formée sur un substrat temporaire 60 (pouvant avoir le même CTE que la couche utile 10 ou un CTE intermédiaire entre celui de la couche utile 10 et celui du substrat support 20), puis reportée sur le substrat support 20. L'implantation d'ions légers requise pour le procédé Smart Cut est alors mise à profit pour former la zone 30 de nanocavités 31, évitant une étape d'implantation supplémentaire. Dans ce troisième mode de réalisation néanmoins, il y a peu de flexibilité sur l'épaisseur fonctionnelle de la zone 30 et sur les caractéristiques (dimensions, densité,...) des nanocavités 31, les paramètres d'implantation étant dictés en premier lieu par le procédé Smart Cut.

### Exemple 1 :

Un substrat donneur 11 en LiNbO₃ est implanté au niveau de sa deuxième face 2, avec des ions d'hélium, à une énergie de 180 keV et une dose de 3,5.10¹⁶ He/cm². Avantageusement, une couche de protection, par exemple en SiO₂, est déposée sur la deuxième face 2, préalablement à l'implantation, afin de limiter la contamination du substrat donneur 11 durant l'étape d'implantation.

Une telle implantation forme typiquement une zone 30 de nanocavités 31 d'épaisseur fonctionnelle de l'ordre de 700 nm, à une distance de l'ordre de 350 nm de la deuxième face 2.

La couche de protection est retirée par gravure chimique.

Un traitement thermique à 700°C pendant 2h est effectué pour stabiliser les nanocavités 31 et évacuer tout ou partie des espèces d'hélium du substrat donneur 11.

Le substrat donneur 11 et un substrat support 20 en silicium, par exemple d'épaisseurs respectives 350 microns et 625 microns, sont ensuite soumis à des séquences de nettoyage, avant d'être assemblés par adhésion moléculaire, formant ainsi une structure hybride collée 101. La face 2 du substrat donneur 11 est de très bonne qualité, compatible avec un collage direct, l'implantation d'espèces gazeuses pour former la zone 30 ne générant pas de déformations ou de dommages superficiels.

Des étapes successives de rodage (grinding) et de polissage sont appliquées à la première face 1' du substrat donneur 11, jusqu'à l'obtention de la couche utile 10, d'épaisseur utile 20 microns. La structure hybride 100 selon l'invention est ainsi formée.

Cette structure est adaptée à l'élaboration d'un dispositif à ondes acoustiques de surface 200, incluant notamment la formation d'électrodes métalliques 50 interdigitées sur la première face 1 de la couche utile 10. La présence de la zone 30 de nanocavités 31 selon l'invention permet d'atténuer voire d'éliminer les réflexions parasites d'ondes acoustiques sur l'interface entre la couche utile 10 et le substrat support 20 : les ondes acoustiques se propageant en direction de ladite interface sont réfléchies en de multiples directions, donc diffusées par la pluralité de nanocavités 31 formant la zone 30.

### Exemple 2 :

Une couche de masquage est formée sur la deuxième face 2 d'un substrat donneur 11 en LiTaO₃, donnant lieu à des régions masquées et à des régions exposées. Les régions exposées forment par exemple des pavés circulaires, comme illustré en vue de dessus sur la figure 2c, séparés entre eux par des régions masquées. Le diamètre des régions exposées est de 5 microns, l'espacement entre deux régions exposées voisines est également de 5 microns.

Le substrat donneur 11 est ensuite implanté au niveau de sa deuxième face 2, avec des ions d'hélium, successivement à plusieurs énergies : 140 keV, 160 keV, 180 keV et avec une dose de 2.10¹⁶ He/cm₂ appliquée pour chaque énergie.

La couche de masquage est retirée par gravure chimique.

Un traitement thermique à 580°C pendant 2h est effectué pour stabiliser les nanocavités 31 et évacuer tout ou partie des espèces gazeuses du substrat donneur 11.

Le substrat donneur 11 et un substrat support 20 en silicium sont ensuite soumis à des séquences de nettoyage, avant d'être assemblés par adhésion moléculaire, formant ainsi une structure hybride collée 101. La face 2 du substrat donneur 11 est de très bonne qualité, compatible avec un collage direct, l'implantation d'espèces gazeuses pour former la zone 30 ne générant pas de déformations ou de dommages superficiels.

Des étapes successives de rodage (grinding) et de polissage sont appliquées à la première face 1' du substrat donneur 11, jusqu'à l'obtention de la couche utile 10, d'épaisseur utile 20 microns. La structure hybride 100 selon l'invention est ainsi formée.

Cette structure est adaptée à l'élaboration d'un dispositif à ondes acoustiques de surface 200, incluant notamment la formation d'électrodes métalliques 50 interdigitées sur la première face 1 de la couche utile 10. La présence de la zone 30 de nanocavités 31 selon l'invention permet d'atténuer voire d'éliminer les réflexions parasites d'ondes acoustiques sur l'interface entre la couche utile 10 et le substrat support 20 : les ondes acoustiques se propageant en direction de ladite interface sont réfléchies en de multiples directions, donc diffusées par la pluralité de nanocavités 31 formant la zone 30.

## Revendications

1. Structure hybride (100) pour dispositif à ondes acoustiques de surface comprenant une couche utile (10) de matériau piézoélectrique présentant une première face (1) libre et une deuxième face (2) disposée sur un substrat support (20) dont le coefficient de dilatation thermique est inférieur à celui de la couche utile (10), la structure hybride (100) étant **caractérisée en ce que** la couche utile (10) comprend une zone (30) de nanocavités (31).

2. Structure hybride (100) pour dispositif à ondes acoustiques de surface selon la revendication précédente, dans laquelle la zone (30) de nanocavités (31) a une épaisseur fonctionnelle comprise entre 50nm et 3 microns.

3. Structure hybride (100) pour dispositif à ondes acoustiques de surface selon l'une des revendications précédentes, dans laquelle la zone (30) de nanocavités (31) se situe à une distance de plus de 50nm de la deuxième face (2) de la couche utile (10).

4. Structure hybride (100) pour dispositif à ondes acoustiques de surface selon l'une des revendications précédentes, dans laquelle les nanocavités (31) ont, au moins en partie, une dimension maximale comprise entre 1nm et 500nm.

5. Structure hybride (100) pour dispositif à ondes acoustiques de surface selon l'une des revendications précédentes, dans laquelle la zone (30) de nanocavités (31) s'étend dans un plan parallèle à la deuxième face (2) de la couche utile (10).

6. Structure hybride (100) pour dispositif à ondes acoustiques de surface selon l'une des revendications précédentes, dans laquelle le substrat support (20) comprend un matériau choisi parmi le silicium, le verre, la silice, le saphir, l'alumine, le nitrure d'aluminium, le carbure de silicium.

7. Structure hybride (100) pour dispositif à ondes acoustiques de surface selon l'une des revendications précédentes, dans laquelle la couche utile (10) comprend un matériau piézoélectrique choisi parmi le tantalate de lithium (LiTaO₃), le niobate de lithium (LiNbO₃), le quartz, l'oxyde de zinc (ZnO).

8. Structure hybride (100) pour dispositif à ondes acoustiques de surface selon l'une des revendications précédentes, comprenant une couche intermédiaire (40) située entre la deuxième face (2) de la couche utile (10) et le substrat support (20).

9. Dispositif à ondes acoustiques de surface (200) comprenant une structure hybride (100) selon l'une des revendications précédentes.

10. Procédé de fabrication d'une structure hybride (100) pour un dispositif à ondes acoustiques de surface comprenant :
a) Une étape de fourniture d'une couche utile (10) de matériau piézoélectrique présentant une première face (1) et une deuxième face (2) ;
b) Une étape de fourniture d'un substrat support (20) présentant un coefficient de dilatation thermique inférieur à celui de la couche utile (10) ;
c) Une étape d'assemblage de la deuxième face (2) de la couche utile (10) sur le substrat support (20) ;
Le procédé étant **caractérisé en ce qu'**il comprend une étape d'introduction d'espèces gazeuses dans la couche utile (10) pour former une zone (30) de nanocavités (31).

11. Procédé de fabrication d'une structure hybride (100) selon la revendication précédente, dans lequel l'étape d'introduction d'espèces gazeuses comprend au moins une implantation d'ions choisis parmi l'hydrogène, l'hélium, l'argon et autres gaz nobles.

12. Procédé de fabrication d'une structure hybride (100) selon l'une des 2 revendications précédentes, comprenant une étape de traitement thermique après l'étape d'introduction d'espèces gazeuses.

13. Procédé de fabrication d'une structure hybride (100) selon l'une des 3 revendications précédentes, dans lequel l'introduction d'espèces gazeuses dans la couche utile (10) est réalisée localement par application d'un masque.

## Patentansprüche

1. Hybridstruktur (100) für eine akustische Oberflächenwellen-Vorrichtung mit einer Nutzschicht (10) aus piezoelektrischem Material, die eine erste freie Fläche (1) und eine zweite Fläche (2) aufweist, die auf einem Trägersubstrat (20) angeordnet sind, dessen thermischer Ausdehnungskoeffizient kleiner als der der Nutzschicht (10) ist, wobei die Hybridstruktur (100) **dadurch gekennzeichnet ist, dass** die Nutzschicht (10) einen Bereich (30) mit Nanokavitäten (31) umfasst.

2. Hybridstruktur (100) für eine akustische Oberflächenwellen-Vorrichtung nach dem vorhergehenden Anspruch, wobei der Bereich (30) mit Nanokavitäten (31) eine funktionelle Dicke zwischen 50 nm und 3 Mikron aufweist.

3. Hybridstruktur (100) für eine akustische Oberflächenwellen-Vorrichtung nach einem der vorhergehenden Ansprüche, wobei der Bereich (30) mit Nanokavitäten (31) in einem Abstand von mehr als 50 nm von der zweiten Seite (2) der Nutzschicht (10) liegt.

4. Hybridstruktur (100) für eine akustische Oberflächenwellen-Vorrichtung nach einem der vorhergehenden Ansprüche, wobei die Nanokavitäten (31) zumindest teilweise eine maximale Abmessung zwischen 1 nm und 500 nm aufweisen.

5. Hybridstruktur (100) für eine akustische Oberflächenwellen-Vorrichtung nach einem der vorhergehenden Ansprüche, wobei sich der Bereich (30) mit Nanokavitäten (31) in einer Ebene parallel zur zweiten Seite (2) der Nutzschicht (10) erstreckt.

6. Hybridstruktur (100) für eine akustische Oberflächenwellen-Vorrichtung nach einem der vorhergehenden Ansprüche, wobei das Trägersubstrat (20) ein Material umfasst, das aus Silizium, Glas, Siliziumdioxid, Saphir, Aluminiumoxid, Aluminiumnitrid und Siliziumkarbid ausgewählt ist.

7. Hybridstruktur (100) für eine akustische Oberflächenwellen-Vorrichtung nach einem der vorhergehenden Ansprüche, wobei die Nutzschicht (10) ein piezoelektrisches Material umfasst, das aus Lithiumtantalat (LiTaO₃), Lithiumniobat (LiNbO₃), Quarz, Zinkoxid (ZnO) ausgewählt ist.

8. Hybridstruktur (100) für eine akustische Oberflächenwellen-Vorrichtung nach einem der vorhergehenden Ansprüche, mit einer Zwischenschicht (40), die zwischen der zweiten Seite (2) der Nutzschicht (10) und dem Trägersubstrat (20) angeordnet ist.

9. Akustische Oberflächenwellen-Vorrichtung (200), umfassend eine Hybridstruktur (100) nach einem der vorhergehenden Ansprüche.

10. Verfahren zur Herstellung einer Hybridstruktur (100) für eine akustische Oberflächenwellen-Vorrichtung, umfassend:
a) einen Schritt zur Bereitstellung einer Nutzschicht (10) aus piezoelektrischem Material, die eine erste Seite (1) und eine zweite Seite (2) aufweist;
b) einen Schritt zur Bereitstellung eines Trägersubstrats (20), das einen niedrigeren Wärmeausdehnungskoeffizienten als die Nutzschicht (10) hat;
c) einen Schritt des Zusammenfügens der zweiten Seite (2) der Nutzschicht (10) auf dem Trägersubstrat (20);
wobei das Verfahren **dadurch gekennzeichnet ist, dass** es einen Schritt des Einbringens von Gasarten in die Nutzschicht (10) umfasst, um einen Bereich (30) mit Nanokavitäten (31) zu bilden.

11. Verfahren zur Herstellung einer Hybridstruktur (100) nach dem vorhergehenden Anspruch, wobei der Schritt des Einbringens von Gasarten mindestens eine Einbringung von Ionen, ausgewählt aus Wasserstoff, Helium, Argon und anderen Edelgasen, umfasst.

12. Verfahren zur Herstellung einer Hybridstruktur (100) nach einem der beiden vorhergehenden Ansprüche, umfassend einen Wärmebehandlungsschritt nach dem Schritt des Einbringens von Gasarten.

13. Verfahren zur Herstellung einer Hybridstruktur (100) nach einem der drei vorhergehenden Ansprüche, wobei das Einbringen von Gasarten in die Nutzschicht (10) lokal durch Aufbringen einer Maske erfolgt.

## Claims

1. Hybrid structure (100) for a surface acoustic wave device, comprising a useful layer (10) made of piezoelectric material having a free first face (1) and a second face (2) arranged on a support substrate (20), the coefficient of thermal expansion of which is lower than that of the useful layer (10), the hybrid structure (100) being **characterized in that** the useful layer (10) comprises a region (30) of nanocavities (31).

2. Hybrid structure (100) for a surface acoustic wave device according to the preceding claim, wherein the region (30) of nanocavities (31) has a functional thickness of between 50 nm and 3 microns.

3. Hybrid structure (100) for a surface acoustic wave device according to either of the preceding claims, wherein the region (30) of nanocavities (31) is located at a distance of more than 50 nm from the second face (2) of the useful layer (10).

4. Hybrid structure (100) for a surface acoustic wave device according to any of the preceding claims, wherein the nanocavities (31) have, at least in part, a maximum dimension of between 1 nm and 500 nm.

5. Hybrid structure (100) for a surface acoustic wave device according to any of the preceding claims, wherein the region (30) of nanocavities (31) extends in a plane which is parallel to the second face (2) of the useful layer (10).

6. Hybrid structure (100) for a surface acoustic wave device according to any of the preceding claims, wherein the support substrate (20) comprises a material selected from silicon, glass, silica, sapphire, alumina, aluminum nitride or silicon carbide.

7. Hybrid structure (100) for a surface acoustic wave device according to any of the preceding claims, wherein the useful layer (10) comprises a piezoelectric material selected from lithium tantalate (LiTaO₃), lithium niobate (LiNbO₃), quartz or zinc oxide (ZnO).

8. Hybrid structure (100) for a surface acoustic wave device according to any of the preceding claims, comprising an intermediate layer (40) located between the second face (2) of the useful layer (10) and the support substrate (20).

9. Surface acoustic wave device (200), comprising a hybrid structure (100) according to any of the preceding claims.

10. Method for manufacturing a hybrid structure (100) for a surface acoustic wave device, comprising:
a) a step of supplying a useful layer (10) made of piezoelectric material and having a first face (1) and a second face (2);
b) a step of supplying a support substrate (20) having a coefficient of thermal expansion lower than that of the useful layer (10);
c) a step of joining the second face (2) of the useful layer (10) onto the support substrate (20);
the method being **characterized in that** it comprises a step of introducing gaseous species into the useful layer (10) in order to form a region (30) of nanocavities (31).

11. Method for manufacturing a hybrid structure (100) according to the preceding claim, wherein the step of introducing gaseous species comprises at least one implantation of ions selected from hydrogen, helium, argon and other noble gases.

12. Method for manufacturing a hybrid structure (100) according to either of the 2 preceding claims, comprising a thermal treatment step after the step of introducing gaseous species.

13. Method for manufacturing a hybrid structure (100) according to any of the 3 preceding claims, wherein introducing gaseous species into the useful layer (10) is carried out locally by applying a mask.
